# EUROPEAN PATENT APPLICATION

(11) **EP 2 772 938 A1**
(43) Date of publication of application: **03.09.2014**
(21) Application number: 13184252.8
(22) Date of filing: 13.09.2013
(51) Int. Cl.: H01L 25/075, H01L 33/60, F21V 7/00, F21Y 101/02

(54) **Light emitting diode backlight module field of the invention**

(30) Priority: 27.02.2013 TW 102106958
(71) Applicant: Wistron Corporation, 22181 New Taipei City (TW)
(72) Inventor: Perng, Chiy-Ferng, 22181 New Taipei City (TW)
(74) Representative: Jenkins, Peter David

(57) **Abstract**

A light emitting diode (LED) backlight module (100) includes a transparent conductive substrate (2) that has an electrode-bearing surface (211) and a plurality of transparent conductive electrodes (22) disposed on the electrode-bearing surface (211), an LED chip (3) that is welded on the transparent conductive electrodes (22) by flip-chip packaging techniques, and a reflecting member (4) that is spaced apart from and that corresponds in position to the LED chip (3) so as to reflect light generated from the LED chip (3) to the transparent conductive substrate (2).

## Description

### FIELD OF THE INVENTION

The disclosure relates to a backlight module, more particularly to a light emitting diode (LED) backlight module having a reflecting member.

### BACKGROUND OF THE INVENTION

At present, most of direct-type LED backlight modules use LEDs that are packaged in the plastic lead chip carrier (PLCC) package as the light source. Since the emitting angle of the LEDs is about 120 degrees, an optical system that includes optical components, such as a light guide plate and a light diffusion sheet, etc., is required to guide and to uniformly diffuse the light generated from the LEDs. However, the aforementioned structural design of the LED backlight modules has the following disadvantages:
(1) Since the optical system tends to absorb a portion of the light generated by the LEDs, the illumination efficiency of the backlight module is reduced, leading to insufficient brightness. Thus, the conventional backlight module has to use a greater number of LEDs to maintain the sufficient brightness, which results in an increase in manufacturing cost.
(2) The optical system in its entirety needs to have a predetermined thickness so as to make the light reach a predetermined scattering angle. Thus, the backlight module incorporating with the conventional optical system inevitably has a relatively large thickness.
(3) Use of the conventional optical system tends to result in an increase in the manufacturing cost of the backlight module, and the assembly process of the backlight module is relatively complicated and inconvenient. Furthermore, deviations and seams tend to be generated among the optical components during assembly operations thereof, and the halo effect is caused thereby.

### SUMMARY OF THE INVENTION

Therefore, an object of the disclosure is to provide an LED backlight module that is capable of enhancing the illumination efficiency of the LED chip and of decreasing the amount of the LED chips so as to reduce the production cost of the LED backlight module.

Another object of the disclosure is to provide an LED backlight module that is capable of reducing the thickness and volume of the LED backlight module so as to reduce the production cost of the LED backlight module, thereby the assembling process of the LED backlight module being simplified and convenient.

According to the disclosure, an LED backlight module includes a transparent conductive substrate, an LED chip and a reflecting member.

The transparent conductive substrate includes an electrode-bearing surface and a plurality of transparent conductive electrodes disposed on the electrode-bearing surface. The LED chip is welded on the transparent conductive electrodes by flip-chip packaging techniques. The reflecting member is spaced apart from and corresponds in position to the LED chip so as to reflect light generated from the LED chip to the transparent conductive substrate.

Preferably, the reflecting member includes at least one first reflecting surface that diverges toward the transparent conductive substrate.

Preferably, in addition to the first reflecting surface, the reflecting member further includes at least one second reflecting surface that is connected to the first reflecting surface and that converges toward the transparent conductive substrate.

Preferably, the reflecting member is concentric waves-shaped and includes a plurality of the first reflecting surfaces and a plurality of the second reflecting surfaces. The first reflecting surfaces and the second reflecting surfaces are radially alternately arranged.

Preferably, the reflecting member is cup-shaped and in addition to the first reflecting surface, further includes a curved reflecting surface protruding toward the electrode-bearing surface. The first reflecting surface is connected to an outer periphery of the curved reflecting surface of the reflecting member and extends toward the electrode-bearing surface.

### BRIEF DESCRIPTION OF THE DRAWINGS

Other features and advantages of the disclosure will become apparent in the following detailed description of the embodiment with reference to the accompanying drawings, of which:
Figure 1 is a sectional schematic view of the first embodiment of an LED backlight module according to the disclosure for illustrating the assembly relationship among constitutional components of the LED backlight module;
Figure 2 is a top schematic view of the first embodiment for illustrating a reflecting member of the LED backlight module;
Figure 3 is a fragmentary sectional schematic view of the first embodiment for illustrating the optical path of the light generated by an LED chip;
Figure 4 is a sectional schematic view of the second embodiment of a backlight module according to the disclosure for illustrating the assembly among constitutional components of the LED backlight module;
Figure 5 is a top schematic view of the second embodiment for illustrating a reflecting member of the LED backlight module; and
Figure 6 is a fragmentary sectional schematic view of the second embodiment for illustrating the optical path of the light generated by an LED chip.

### DETAILED DESCRIPTION OF THE INVENTION

Before the disclosure is described in greater detail, it should be noted herein that like elements are denoted by the same reference numerals throughout the disclosure.

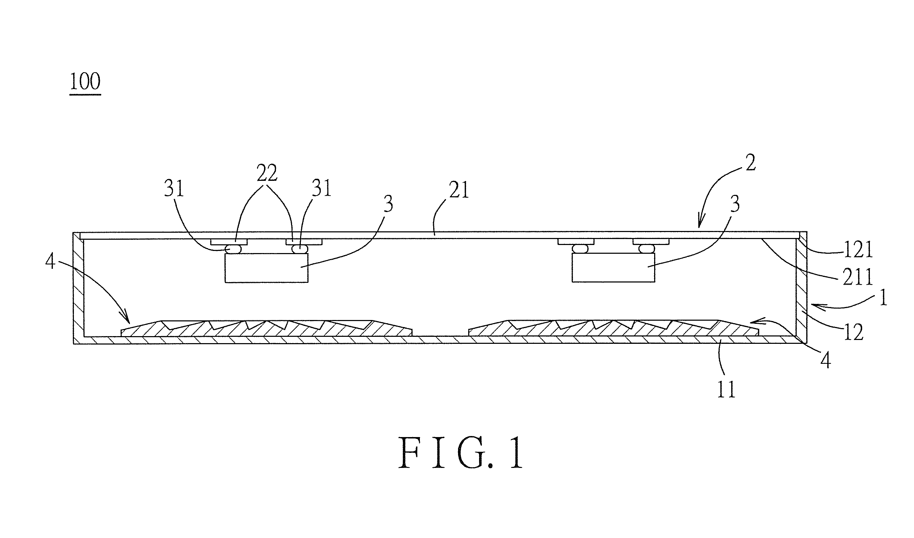

Referring to Figure 1, the first embodiment of an LED backlight module 100 according to this disclosure includes a frame 1, a transparent conductive substrate 2, a plurality of LED chips 3 and a plurality of reflecting members 4.

Referring to Figures 1, 2 and 3, the frame 1 includes a base plate 11, and a surrounding wall 12 that projects upwardly from the periphery of the base plate 11. The surrounding wall 12 is formed with a shoulder portion that is spaced apart from the base plate 11 and that has a supporting surface 121. The transparent conductive substrate 2 includes a plate body 21 that is supported on the shoulder portion and that is formed with an electrode-bearing surface 211 abutting against the supporting surface 121 of the shoulder portion of the surrounding wall 12, and a plurality of transparent conductive electrodes 22. The plate body 21 is made of a transparent material, such as glass, plastics, etc. The electrode-bearing surface 211 of the plate body 21 is coated with an indium tin oxide conductive layer. Each of the transparent conductive electrodes 22 may be made of indium tin oxide and is disposed on the electrode-bearing surface 211 of the plate body 21 with the indium tin oxide conductive layer interposed therebetween and electrically connected thereto.

Each of the LED chips 3 is welded to corresponding ones of the transparent conductive electrodes 22 by flip-chip packaging techniques. Moreover, each of the LED chips 3 is welded to the corresponding transparent conductive electrodes 22 through corresponding ones of bonding pads 31 such that each of the LED chips 3 is connected electrically to the indium tin oxide conductive layer of the transparent conductive substrate 2.

Each of the reflecting members 4 is disposed on the base plate 11 of the frame 1, is spaced apart from the electrode-bearing surface 211 of the plate body 21 of the transparent conductive substrate 2 and corresponds in position to the corresponding one of the LED chips 3 for reflecting light generated from the corresponding LED chip 3 to the transparent conductive substrate 2.

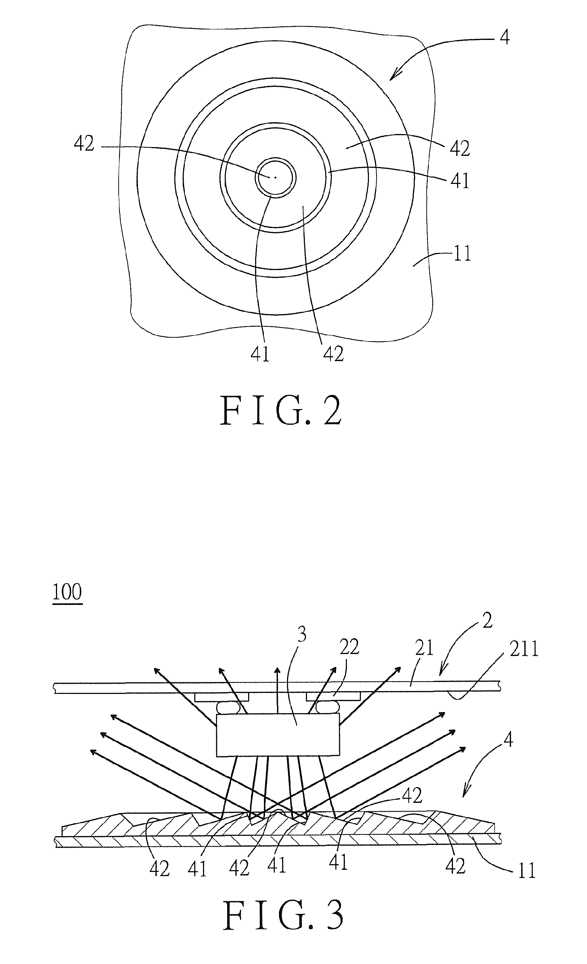

Since each of the LED chips 3 is welded on the transparent conductive substrate 2 by the flip-chip packaging techniques, and since the plate body 21 and the transparent conductive electrodes 22 of the transparent conductive substrate 2 are respectively made of a transparent material, the light generated by the LED chips 3 is not blocked and may travel in almost all directions, i.e., with an emitting angle up to about 360 degrees. The light generated from the LED chips 3 and emitting toward the transparent conductive substrate 2 tends to directly penetrate and be refracted by the transparent conductive substrate 2 so as to be incident into a liquid crystal display panel (not shown), whereas the light generated from the LED chips 3 and emitting toward the base plate 11 tends to be reflected by the reflecting members 4 and change the scattering angle thereof so as to increase the number of optical paths of the light and enlarge the illuminated area of the electrode-bearing surface 211. Therefore, the reflected light is able to uniformly penetrate and to be refracted by the transparent conductive substrate 2 to be incident into the liquid crystal display panel. Since the fraction of the light refracted by the transparent conductive substrate 2 is relatively small, in Figure 3, the optical paths of the light are primarily represented by the straight lines that directly penetrate the transparent conductive substrate 2. Through the aforementioned design, the illumination efficiency of the LED chips 3 is increased, and the number and the manufacturing cost of the LED chips 3 are both decreased.

The structure of the LED backlight module 100 is to be illustrated in detail as follows:
Referring Figures 2 and 3, in this embodiment, each of the reflecting members 4 has a plate-like structure. As shown in the top schematic view of Figure 2, each of the reflective members 4 has a configuration of concentric waves and includes a plurality of first reflecting surfaces 41 that diverge from the base plate 11 toward the transparent conductive substrate 2 and a plurality of second inclined reflective surfaces 42 that converge from the base plate 11 toward the transparent conductive substrate 2 so as to correspondingly reflect the light generated from the LED chips 3. Preferably, each of the first and second reflecting surfaces 41, 42 has a metallic coating made from silver or aluminum by sputtering or vapor deposition techniques. Preferably, the first reflecting surfaces 41 and the second reflecting surfaces 42 are radially alternately disposed. At the center of each of the reflecting members 4, a second reflecting surface 42 forms a cone right under the corresponding LED chip 3. Through the structural design of the first and second reflecting surfaces 41 and 42, the scattering angle of the light reflected by the reflecting members 4 is effectively increased, and the area of the plate body 21 of the transparent conductive substrate 2 illuminated by the reflected light is increased.

In comparison with the conventional direct type LED backlight module, the LED backlight module 100 of this embodiment is dispensed with the optical system composed of optical components such as light guide plates, diffuser sheets, etc. As such, the drawback of reduced illumination efficiency in the conventional LED backlight module can be effectively circumvented and sufficient illumination can be obtained by means of a reduced number of the LED chips 3. Therefore, the manufacturing cost of the LED backlight module 100 is significantly reduced. In addition, the dispensation of the optical system not only effectively reduces the overall thickness and volume of the LED backlight module 100, but also further reduces the production cost of the LED backlight module 100 due to the relatively low cost of the reflecting members 4, thereby making the assembly process of the LED backlight module 100 simplified and convenient.

It should be noted that, in this embodiment, the other surface of the plate body 21 opposite to the electrode-bearing surface 211 can be formed with an optical structure by injection molding or etching techniques. Thus, the light incident into the plate body 21 can be uniformly emitted from the other surface of the plate body 21 after being mixed and diffused within the plate body 21. Alternatively, a diffusing agent can be added to the transparent conductive substrate 2 during the manufacturing process thereof. Besides, in this embodiment, the first and second inclined reflective surfaces 41, 42 of the reflective members 4 are exemplified in plurality. However, in practice, the numbers of the first and second reflecting surfaces 41, 42 can be adjusted according to the actual requirement and can be set to one, for example. Moreover, the inclination angle of each of the first and second reflecting surfaces 41, 42 with respect to the base plate 11 can also be adjusted according to the actual requirement, and hence is not limited to what is shown in the Figures.

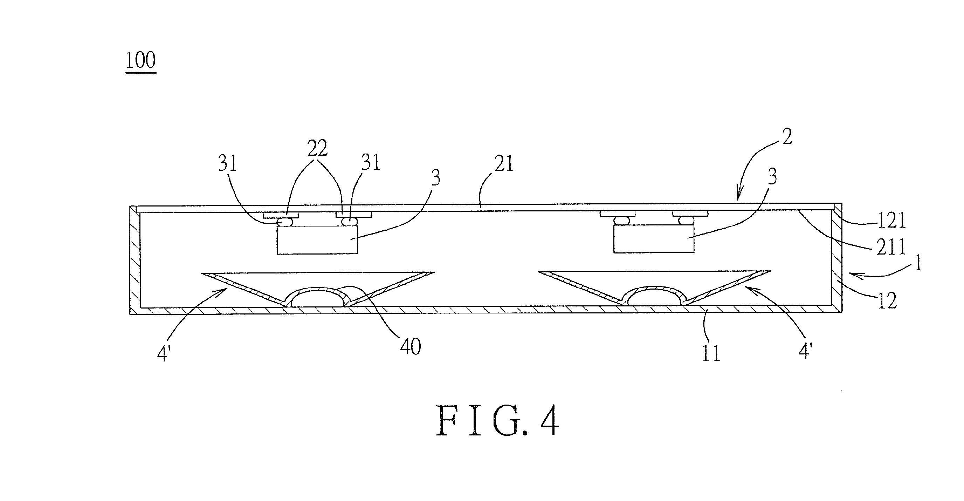

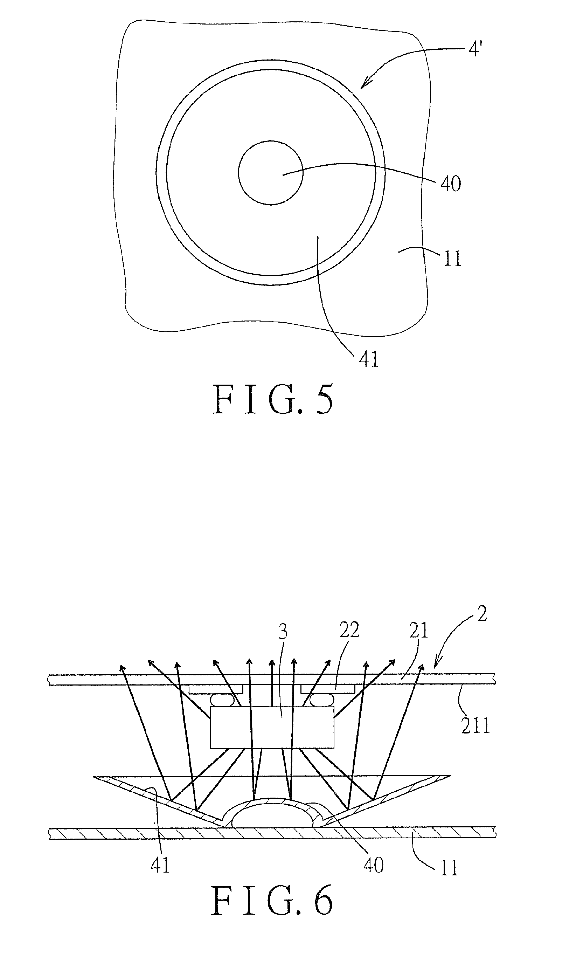

Referring to Figures 4, 5 and 6, the second embodiment of the LED backlight module 100 of this disclosure is shown to be generally identical to the first embodiment except for the structural design of the reflecting members 4'.

In this embodiment, each of the reflecting members 4' is cup-shaped and includes a curved reflecting surface 40 that protrudes toward the electrode-bearing surface 211, and a first reflecting surface 41 that is connected to an outer periphery of the curved reflecting surface 40. The curved reflecting surface 40 is located right under the corresponding LED chip 3. The curved reflecting surface 40 and the first reflecting surface 41 have metallic coatings made from silver or aluminum by sputtering or vapor deposition techniques so as to reflect the light generated by the corresponding one of the LED chips 3. Through the structural design of the first reflecting surface 41 and the curved reflecting surface 40, the scattering angle of the reflected light can be effectively increased so as to increase the area of the electrode-bearing surface 211 of the plate body 21 illuminated by the reflected light.

In view of the foregoing, referring to the LED backlight modules 100 according to the first and second embodiments, through the structural design of welding each of the LED chips 3 to the electrode-bearing surface 211 of the transparent conductive substrate 2 and arranging the reflecting members 4, 4' to reflect the light generated from the LED chips 3 and to increase the emitting angle of the light, the illumination efficiency of the LED chips 3 is significantly increased and the number and the manufacturing cost of the LED chips 3 are both significantly reduced. Moreover, the overall thickness and volume of the LED backlight module 100 are decreased, the overall manufacturing cost of the LEDbacklight module 100 is reduced, and the assembly process of the LED backlight module 100 is simplified and more convenient. Therefore, the objects of this disclosure are achieved.

## Claims

1. A light emitting diode (LED) backlight module (100), **characterized by**:
a transparent conductive substrate (2) that includes an electrode-bearing surface (211) and a plurality of transparent conductive electrodes (22) disposed on said electrode-bearing surface (211);
an LED chip (3) that is welded on said transparent conductive electrodes (22) by flip-chip packaging techniques; and
a reflecting member (4, 4') that is spaced apart from and that corresponds in position to said LED chip (3) so as to reflect light generated from said LED chip (3) to said transparent conductive substrate (2).

2. The light emitting diode backlight module (100) as claimed in Claim 1, **characterized in that** said reflecting member (4, 4') includes at least one first reflecting surface (41) that is disposed on a side of said LED chip (3) opposite to said transparent conductive substrate (2) and that diverges toward said transparent conductive substrate (2).

3. The light emitting diode backlight module (100) as claimed in Claim 1, **characterized in that** said reflecting member (4) further includes at least one second reflecting surface (42) that is connected to said first reflecting surface (41) and that
converges toward said transparent conductive substrate (2).

4. The light emitting diode backlight module (100) as claimed in Claim 2, **characterized in that** said reflecting member (4) has a configuration of concentric waves and includes a plurality of said first reflecting surfaces (41) and a plurality of said second reflecting surfaces (42), said first reflecting surfaces (41) and said second reflecting surfaces (42) being radially alternately arranged.

5. The light emitting diode backlight module (100) as claimed in Claim 2, **characterized in that** said reflecting member (4') is cup-shaped and further includes a curved reflecting surface (40) protruding toward said electrode-bearing surface (211), said first reflecting surface (41) being connected to an outer periphery of said curved reflecting surface (40) of said reflecting member (4') and extending toward said electrode-bearing surface (211).
